Europäisches Patentamt

European Patent Office

Office européen des brevets

(19)

(11) Numéro de publication: **0 347 292**
**A1**

## (12) DEMANDE DE BREVET EUROPEEN

(21) Numéro de dépôt: **89401609.6**

(22) Date de dépôt: **09.06.89**

(51) Int. Cl.⁴: **G 01 R 33/26**

(30) Priorité: **15.06.88 FR 8807995**

(43) Date de publication de la demande:
**20.12.89 Bulletin 89/51**

(84) Etats contractants désignés: **DE GB IT NL SE**

(71) Demandeur: **THOMSON-CSF**
**51, Esplanade du Général de Gaulle**
**F-92800 Puteaux (FR)**

(72) Inventeur: **Aspect, Alain**
**THOMSON-CSF SCPI**
**F-92045 Paris La Défense Cédex 67 (FR)**

**Himbert, Marc**
**THOMSON-CSF SCPI**
**F-92045 Paris La Défense Cédex 67 (FR)**

**Weisbuch, Claude**
**THOMSON-CSF SCPI**
**F-92045 Paris La Défense Cédex 67 (FR)**

**Doisy, Martine**
**THOMSON-CSF SCPI**
**F-92045 Paris La Défense Cédex 67 (FR)**

**Cremoux, Baudouin**
**THOMSON-CSF SCPI**
**F-92045 Paris La Defense Cedex 67 (FR)**

(74) Mandataire: **Grynwald, Albert et al**
**THOMSON-CSF SCPI**
**F-92045 PARIS LA DEFENSE CEDEX 67 (FR)**

(54) Système de pompage optique d'une cellule de vapeurs atomiques ou moléculaires et application à un magnétomètre.

(57) Système de pompage optique d'une cellule de vapeurs atomiques on moléculaires comportant au moins une cavité optique possédant au moins une cellulle (1) de vapeurs atomiques, une onde optique de pompage étant couplée à ladite cavité optique.

Application prérérentielle : magnétomètres.

FIG_1

EP 0 347 292 A1

**Description**

## SYSTEME DE POMPAGE OPTIQUE D'UNE CELLULE DE VAPEURS ATOMIQUES OU MOLECULAIRES ET APPLICATION A UN MAGNETOMETRE

L'invention concerne un système de pompage optique d'une cellule de vapeurs atomiques ou moléculaires et son application à un magnétomètre.

L'excitation de cellules de gaz atomique ou moléculaire tel que l'hélium, le rubidium, le césium à l'aide d'un faisceau lumineux monochromatique est connu et a fait l'objet d'applications dans divers dispositifs tels que magnétomètres.

On trouvera und description d'un magnétomètre utilisant l'effet de résonance magnétique nucléaire dans l'article :

"A nuclear free precession magnetometer using optically polarized He³ gaz" de R.E. Slocum et B.I. Marton dans IEEE d'avril 1974.

L'utilisation des propriétés de pompage optique de l'hélium 3 et de l'hélium 4 est maintenant bien établie dans la détection des faibles champs magnétiques. Dans le cas de l'hélium 4, on crée par une décharge électrique des atomes dans l'état métastable 2 S. On excite par une lumière résonnante vers 1.08 μm convenablement polarisée une ou plusieurs composantes de la transition 2S-2P à partir de cet état métastable. On oriente ou align ainsi par pompage optique les atomes métastables dans l'état 2 S. Lorsqu'on emploie de l'hélium 3, qui a un spin nucléaire non nul, on oriente aussi le spin nucléaire dans l'état fondamental grâce à l'interaction hyperfine électron-noyau et aux collisions échangeant le spin entre atomes dans l'état métastable et dans l'état fondamental.

Le magnétomètre à hélium 4 est basé sur la mesure de résonance magnétique électronique dans le champ magnétique à mesurer. La fréquence de résonance donne la valeur du champ à mesurer. La résonance électronique est détectée par la variation du coefficient d'absorption induite sur un faisceau de lumière polarisée circulairement à 1.08 μm ou de la polarisation de la lumière de fluorescence.

Le magnétomètre à hélium 3 est basé sur la mesure de la résonance magnétique nucléaire ou de la précession libre des noyaux polarisés dans l'état fondamental. Dans l'état fondamental, le temps de relaxation nucléaire peut être très long, supérieur à 24 heures si l'on utilise une cellule à gaz adéquate, ce qui permet de séparer les opérations d'orientation du spin nucléaire et de mesure de la fréquence de précession de ces spins orientés. L'opération de mesure peut donc être effectuée en continu ou répétée à intervalles réguliers sans avoir à orienter les noyaux.

Ces magnétomètres opèrent avec des pressions optimales d'hélium de l'ordre de 1 torr. On peut montrer que la puissance optique nécessaire à l'obtention de forts taux d'orientation ou d'alignement électronique ou nucléaire est de l'ordre de quelques centaines de milliwatts dans les géométries habituelles. L'utilisation de lasers accordés sur l'une des fréquences de transition nécessite donc une puissance relativement élevée, surtout lorsque l'on considère les lasers semiconducteurs comme sources. De plus, ceux-ci ont des raies larges par rapport aux raies de l'hélium lorsqu'ils ne sont pas monomodes.

La présente invention a pour objet un moyen d'augmenter l'efficacité du pompage de cellules à gaz atomique ou moléculaire, et notamment de cellules d'hélium, par une diode laser.

L'invention concerne donc un système de pompage optique d'une cellule de vapeurs atomiques ou moléculaires caractérisé en ce qu'il comporte au moins une cavité optique résonnante comportant au moins une cellule de vapeurs atomiques, une onde optique de pompage étant couplée à ladite cavité optique.

Les différents objets et caractéristiques de l'invention apparaîtront plus clairement dans la description qui va suivre faite à titre d'exemple en se reportant aux figures annexées qui représentent :

- la figure 1, un exemple de réalisation simplifié d'un système de pompage optique selon l'invention ;
- la figure 2, une variante de réalisation du système de la figure 1 ;
- la figure 3, un exemple de réalisation à cavité repliée du système de l'invention ;
- la figure 4, un exemple de réalisation à cavité en anneau du système de l'invention ;
- la figure 5, une application de l'invention à un magnétomètre.

Selon l'invention on place une cellule de vapeurs atomiques ou moléculaires dans une cavité optique recevant d'une source lumineuse une onde lumineuse d'excitation.

La cellule, par exemple en verre du type connu sous le nom commercial Corning 1723, est remplie d'hélium 3 ou d'hélium 4, ou d'un mélange de gaz comprenant de l'hélium 3 ou 4 qui permet d'optimiser l'efficacité de pompage.

Par un des procédés habituels, on renvoie sur le laser une partie du rayonnement de la cavité pour coupler la cavité et le laser. Ceci peut simplement être obtenu par renvoi sur le laser d'une partie du rayonnement transmis ou réfléchi de manière résonnante par la cavité, ou par collimation entre le laser et un miroir externe (ce qui en fait un laser à cavité externe) ou par tout autre moyen. Ce montage permet à la fois un certain nombre d'effets :

1. Il permet de transformer le laser semiconducteur en un laser monomode longitudinal, s'il ne l'est déjà, grâce au couplage entre le laser et la cavité. L'effet laser se produit à une fréquence très proche d'une fréquence de résonance de la cavité.

2. Il y a affinement de la raie du laser semiconducteur grâce à la finesse du Perot-Fabry.

3. Enfin et surtout, il y a accumulation d'énergie dans la cavité, proportionnelle à la finesse F de la cavité. L'intensité lumineuse circulant dans la cavité est augmentée d'un facteur F/©. On peut donc obtenir facilement une intensité de quelques centaines de milliwatts à l'intérieur d'une cavité.

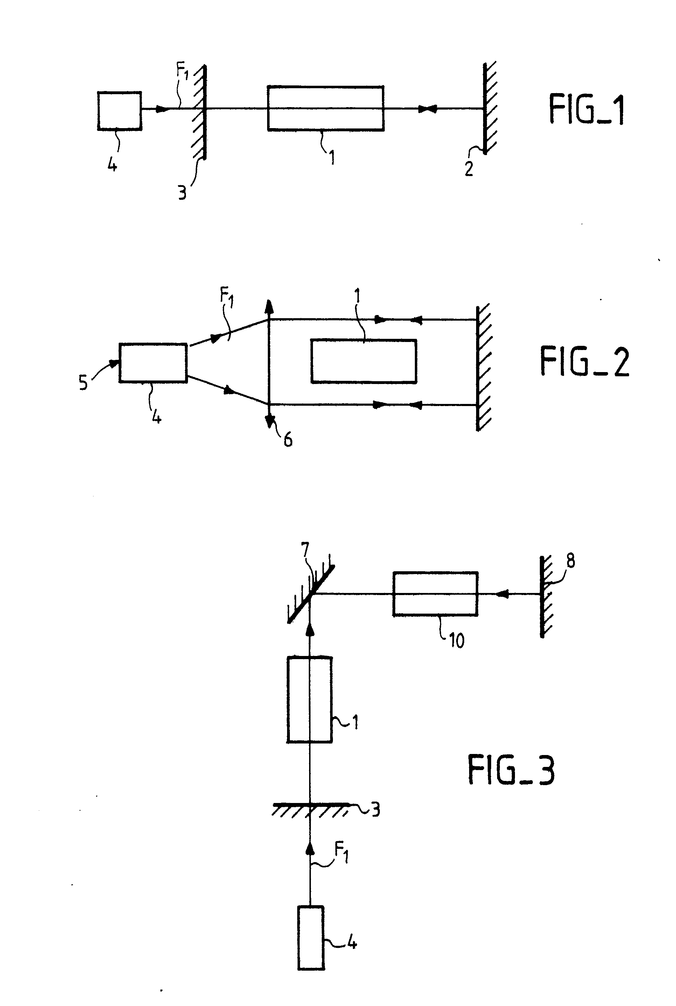

La figure 1 représente un premier exemple de réalisation du système de pompage optique selon l'invention.

Une cellule de vapeurs atomiques 1 est placée entre deux miroirs 2 et 3 et reçoit une onde lumineuse $F_1$ fournie par une source 4. Les miroirs 2 et 3 constituent une cavité optique Perot-Fabry à la longueur d'onde lumineuse. Selon l'exemple de la figure 1, les miroirs 2 et 3 sont plans mais ils peuvent être également de surfaces courbes, sphériques notamment. Il peut être parfois nécessaire d'adapter le mode transverse du laser au mode de la cavité, par exemple à l'aide d'une lentille. Il est également possible que le miroir 3 soit remplacé par la face de sortie du miroir 4.

La fréquence du laser est ajustée par la longueur de la cavité de façon à exciter de manière optimale la vapeur d'hélium. Une technique possible est d'utiliser une cavité suffisamment longue pour qu'il y ait toujours un de ses modes dans chacune des raies d'absorption Doppler de l'hélium. On ajuste ensuite la longueur d'onde du maximum de la courbe de gain du laser pour que l'émission ait lieu sur le mode de la cavité considéré. Cet ajustement est fait par le courant du laser ou sa température. On peut aussi utiliser une cavité bien plus courte, pour laquelle on ajustera la longueur afin qu'un mode coïncide avec la transition à exciter. L'accord est mesuré sur un signal de fluorescence de l'hélium ou le signal d'absorption de la cellule. Eventuellement, il peut être utile d'obtenir une émission laser sur plusieurs raies bien choisies de manière à exciter différentes transitions de l'hélium et à ainsi augmenter les taux de polarisation électronique et nucléaire.

Le laser à semiconducteur est de nature quelconque, monomode ou multimode, à double-hétérostructure standard ou à puits quantiques, ou toute autre structure. Une possibilité de matériaux est le système $Ga_{1-x} In_x As/InP$, où la composition x est ajustée pour donner une émission à 1.08 µm.

Le concept d'excitation d'une vapeur atomique par un laser semiconducteur amélioré par l'usage d'une cavité peut être appliqué aux autres lasers pour une telle application, comme le cas due laser LNA pompant un magnétomètre à hélium.

La figure 2 représente un exemple de réalisation de l'invention selon lequel la cavité optique est réalisée par la face 5 de la source 4, une optique 6 permettant de collimater le faisceau lumineux provenant de la source 4 vers la cellule 1.

Selon l'exemple de réalisation de la figure 3, la cavité optique peut être repliée. Elle peut, par exemple, comprendre deux bras faisant par exemple un angle de 90 degrés. Un premier bras est délimité par un premier miroir 3 permettant l'accès du faisceau de pompage $F_1$ et par un deuxième miroir 7 faisant un angle de 45 degrés par exemple, par rapport au faisceau de pompage. Le deuxième bras est délimité par le deuxième miroir 7 et un troisième miroir 8. Chaque bras peut contenir une cellule (1,10) de vapeurs atomiques.

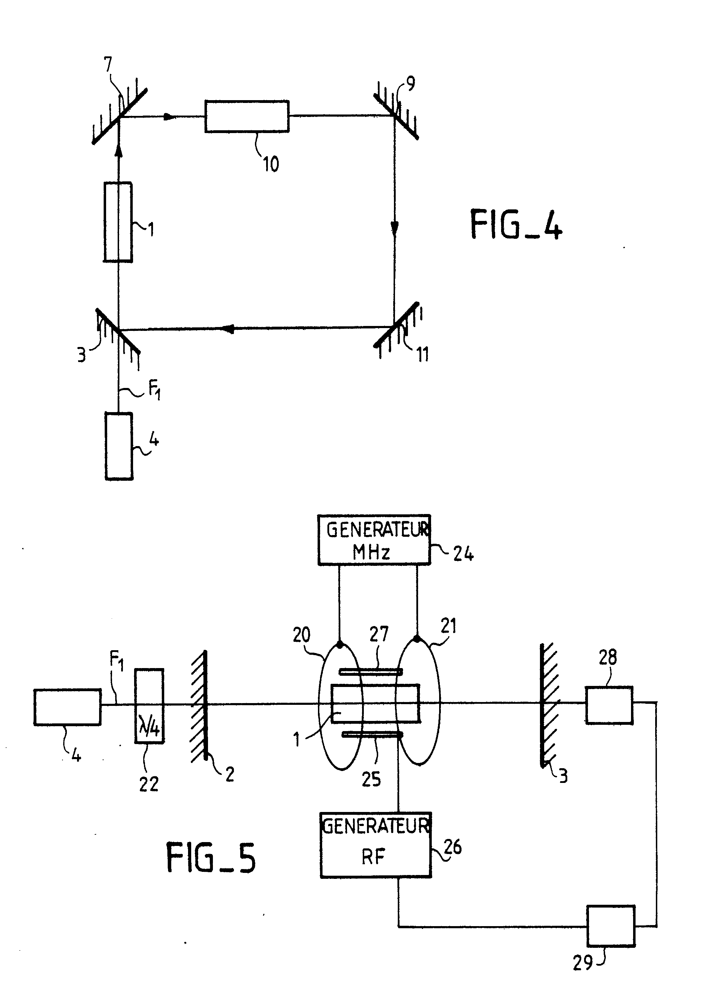

La figure 4 représente un exemple de réalisation dans lequel la cavité optique est en anneau. Le faisceau de pompage $F_1$ pénètre dans la cavité par un premier miroir 3 semi-réfléchissant et l'anneau est réalisé par les miroirs 7,9,11 et 3. Chaque bras de l'anneau peut comporter une cellule de gaz atomiques telles que 1 et 10.

A titre d'exemple, la longueur d'une cavité peut être de 20 cm ce qui permet d'encadrer la fréquence de l'hélium dans le cas ou le gaz de la ou les cellules est de l'hélium.

Il est possible aussi d'utiliser les deux faces émettrices du laser de façon à le coupler à une ou deux cavités suivant les schémas dérivés de ceux décrits précédemment. Par exemple :
- ou bien, le laser est placé dans une seule cavité optique,
- ou bien, une des cavités est couplée au laser pour l'affiner tandis que l'ature sert seulement au pompage optique.

La ou les cellules 1,10 peuvent être de différentes formes, notamment elles peuvent être sphériques ou cylindriques.

Le système de pompage optique ainsi décrit peut être appliqué à un magnétomètre.

La figure 5 représente ainsi un exemple de réalisation d'un magnétomètre à hélium 4 selon l'invention. Ce magnétomètre comporte une cellule 1 d'hélium 4. La cellule 1 est placée dans une cavité optique constituée par exemple de deux miroirs 2 et 3. La cavité optique reçoit un faisceau de pompage $F_1$ d'une source laser 4. Le faisceau de pompage $F_1$ est polarisé linéairement et une lame quart d'onde 22 fournit un faisceau de pompage polarisé circulairement.

Aux deux extrémités de la cellule situées sur l'axe de propagation de l'onde de pompe, deux électrodes 20, 21 ou anneau d'excitation sont portées à une tension alternative par un générateur 24 haute fréquence fournissant un signal de l'ordre de 5 MHz, ce qui permet d'entretenir une décharge douce nécessaire à l'obtention d'atomes d'hélium métastables.

Deux enroulements 25, 27 situés dans des plans parallèles à la direction de propagation du faisceau de pompage F et de part et d'autre de ce faisceau sont alimentés par un générateur radiofréquence 26 et fournissent un champ de radiofréquence.

De préférence, le faisceau de pompage $F_1$ est parallèle à la direction du champ magnétique à mesurer et le champ radiofréquence est perpendiculaire à cette direction.

Le générateur radiofréquence 26 est modulé en fréquence autour d'une valeur réglable de façon à induire la résonance magnétique électronique de l'hélium. Le réglage du champ radiofréquence peut se faire à partir du rayonnement transmis par la cellule 1.

Pour cela une cellule de détection 28 reçoit le rayonnement transmis par la cellule 1 et permet à l'aide d'un circuit de traitement 29 d'agir sur le générateur radiofréquence 26.

Le fonctionnement de ce type magnétomètre est connu dans la technique. On en trouvera une description dans la demande de brevet français 86 06 776.

On trouve également dans cette demande de brevet des dispositions permettant, par un système de détection synchrone, d'obtenir une plus grande précision.

Selon l'invention, la cavité optique permet d'en améliorer l'efficacité en accordant la cavité sur une raie du gaz (hélium) de la cellule.

L'invention est également applicable à un magnétomètre à hélium 3 tel que celui décrit dans la demande de brevet précédemment citée en prévoyant de placer la cellule d'hélium 3 dans une cavité optique.

Il est bien évident que la description qui précède n'a été faite qu'à titre d'exemple non limitatif. D'autres variantes peuvent être envisagées sans sortir du cadre de l'invention.

**Revendications**

1. Système de pompage optique d'une cellule de vapeurs atomiques ou moléculaires, caractérisé en ce qu'il comporte au moins une cavité optique résonnante comportant au moins une cellule (1) de vapeurs atomiques ou moléculaires, une onde optique de pompage étant couplée à ladite cavité optique.

2. Système de pompage optique selon la revendication 1, caractérisé en ce que le gaz de la cellule (1) est de l'hélium.

3. Système de pompage optique selon la revendication 1, caractérisé en ce qu'il comporte un laser à semiconducteurs (4) qui fournit l'onde optique de pompage (F)

4. Système de pompage optique selon la revendication 1, caractérisé en ce que la cavité optique comporte deux miroirs (2,3).

5. Système de pompage optique selon la revendication 4, caractérisé en ce que les miroirs (2,3) sont plans.

6. Système de pompage optique selon la revendication 4, caractérisé en ce que les miroirs (2,3) sont courbes.

7. Système de pompage optique selon la revendication 3, caractérisé en ce que la cavité optique contenant la cellule optique (1) est délimitée par une face du laser (1).

8. Système de pompage optique selon la revendication 1, caractérisé en ce qu'il comporte des moyens (7) permettant de replier le chemin optique dans la cavité.

9. Système de pompage optique selon la revendication 1, caractérisé en ce qu'il comporte des moyens (7,9,11,3) permettant de reboucler le chemin optique dans la cavité.

10. Système de pompage optique selon la revendication 1, caractérisé en ce qu'il utilise les deux faisceaux émis par un laser à semiconducteur, en plaçant celui-ci à l'intérieure d'une cavité optique unique.

11. Système de pompage optique selon la revendication 1, caractérisé en ce qu'il utilise les deux faisceaux émis par un laser semiconducteur et qu'il comporte, associée à chaque faisceau, une cavité optique l'une des cavités servant pour le pompage optique l'autre pour le contrôle du laser.

12. Magnétomètre à gaz pompé optiquement appliquant le système de pompage optique selon l'une quelconque des revendications précédentes, comprenant une cellule à gaz atomique (1) recevant un faisceau de pompage d'une source laser (4), caractérisé en ce que la cellule à gaz est placée dans une cavité optique qui renvoie une partie du faisceau de pompage vers la source laser (4)

FIG_1

FIG_2

FIG_3

FIG_4

FIG_5

Office européen des brevets

**RAPPORT DE RECHERCHE EUROPEENNE**

Numero de la demande

EP 89 40 1609

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | GB-A-1 148 294 (VARIAN ASSOCIATES) * Page 1, lignes 42-52; page 2, lignes 28-36 * | 1 | G 01 R 33/26 |
| Y | | 12 | |
| | --- | | |
| Y | GB-A-2 137 357 (LITTON SYSTEMS INC.) * Page 1, ligne 83 - page 2, ligne 11; page 2, ligne 29 - page 3, ligne 1; figures 1,2 * & FR-A-2 543 747 | 1-3,12 | |
| | --- | | |
| A | US-A-4 327 327 (I.A. GREENWOOD) * Colonne 1, ligne 9 - colonne 2, ligne 25; figure 2 * | 1,10,12 | |
| | --- | | |
| A | EP-A-0 246 146 (CENTRE NATIONAL DE LA RECHERCHE SCIENTIFIQUE) * Page 12, ligne 22 - page 16, ligne 20; figure 5 * & FR-A-2 598 518 (Cat. A,D) | 1-3,12 | |
| | --- | | |
| A | DE-A-3 150 391 (W.-U. STIER) * Page 11, ligne 13 - page 13, ligne 34; figure 2 * | 1,3,10, 12 | **DOMAINES TECHNIQUES RECHERCHES (Int. Cl.4)**<br><br>G 01 C<br>G 01 N<br>G 01 R |
| | ----- | | |

Le présent rapport a été établi pour toutes les revendications

| Lieu de la recherche | Date d'achèvement de la recherche | Examinateur |
|---|---|---|
| LA HAYE | 07-09-1989 | HORAK G.I. |